# EUROPEAN PATENT SPECIFICATION

(11) **EP 1 997 125 B1**
(45) Date of publication and mention of the grant of the patent: **15.11.2017**
(21) Application number: 07712941.9
(22) Date of filing: 19.03.2007
(51) Int. Cl.: H01L 21/20, C30B 23/02, C30B 25/18, C30B 29/40, C30B 29/48, C30B 33/00, C30B 23/00, C30B 25/00, H01L 21/02

(54) **GROWTH METHOD USING NANOCOLUMN COMPLIANT LAYERS AND HVPE FOR PRODUCING HIGH QUALITY COMPOUND SEMICONDUCTOR MATERIALS**
WACHSTUMSVERFAHREN MIT NANOSÄULE-FÜGIGEN SCHICHTEN UND HVPE ZUR HERSTELLUNG VON QUALITATIV HOCHWERTIGEN HALBLEITERVERBUNDMATERIALIEN
PROCÉDÉ DE CROISSANCE AU MOYEN DE COUCHES CONFORMES NANOCOLONAIRES ET DE HVPE POUR LA PRODUCTION DE MATÉRIAUX SEMI-CONDUCTEURS COMPOSÉS DE HAUTE QUALITÉ

(30) Priority: 23.03.2006 GB 0605838
(43) Date of publication of application: 03.12.2008
(73) Proprietor: Nanogan Limited, Queen Square Bath BA1 2JE (GB)
(72) Inventor: WANG, Wang, Nang, Bath BA2 7AY (GB)
(74) Representative: Page Hargrave
(86) International application number: PCT/GB2007/001011
(87) International publication number: WO 2007/107757

(56) References cited:
- EP-A- 1 246 233
- EP-A- 1 422 748
- US-A1- 2002 013 042
- US-A1- 2004 137 732
- US-A1- 2005 199 886
- US-A1- 2005 199 886
- TAKENORI OSADA; TAKESHI OKATO; MINORU OBARA: "Fabrication and characterization of hexagonally assembled ZnO and ZnO:N thin films with buffer layer by pulsed-laser deposition", SPIE, PO BOX 10 BELLINGHAM WA 98227-0010 USA, vol. 5713, 12 April 2005 (2005-04-12), pages 319-325, XP040200040,
- JIN-HO YANG ET AL: "The Effect of Ar/O[sub 2] Sputtering Gas on the Phosphorus-Doped p-Type ZnO Thin Films", JOURNAL OF THE ELECTROCHEMICAL SOCIETY, vol. 153, no. 3, 26 January 2006 (2006-01-26), page G242, XP055193981, ISSN: 0013-4651, DOI: 10.1149/1.2164727
- LIN C C ET AL: "Synthesis and optoelectronic properties of arrayed p-type ZnO nanorods grown on ZnO film/Si wafer in aqueous solutions", CHEMICAL PHYSICS LETTERS, ELSEVIER BV, NL, vol. 404, no. 1-3, 7 March 2005 (2005-03-07), pages 30-34, XP027647860, ISSN: 0009-2614, DOI: 10.1016/J.CPLETT.2005.01.047 [retrieved on 2005-03-07]
- TAKENORI OSADA; TAKESHI OKATO; MINORU OBARA: "Fabrication and characterization of hexagonally assembled ZnO and ZnO:N thin films with buffer layer by pulsed-laser deposition", SPIE, PO BOX 10 BELLINGHAM WA 98227-0010 USA, vol. 5713, 12 April 2005 (2005-04-12), pages 319-325, XP040200040,
- JIN-HO YANG ET AL: "The Effect of Ar/O[sub 2] Sputtering Gas on the Phosphorus-Doped p-Type ZnO Thin Films", JOURNAL OF THE ELECTROCHEMICAL SOCIETY, vol. 153, no. 3, 26 January 2006 (2006-01-26), page G242, XP055193981, ISSN: 0013-4651, DOI: 10.1149/1.2164727
- LIN C C ET AL: "Synthesis and optoelectronic properties of arrayed p-type ZnO nanorods grown on ZnO film/Si wafer in aqueous solutions", CHEMICAL PHYSICS LETTERS, ELSEVIER BV, NL, vol. 404, no. 1-3, 7 March 2005 (2005-03-07), pages 30-34, XP027647860, ISSN: 0009-2614, DOI: 10.1016/J.CPLETT.2005.01.047 [retrieved on 2005-03-07]
- KUSAKABE K ET AL: "Overgrowth of GaN layer on GaN nano-columns by RF-molecular beam epitaxy", JOURNAL OF CRYSTAL GROWTH, ELSEVIER, AMSTERDAM, NL, vol. 237-239, 1 April 2002 (2002-04-01), pages 988-992, XP004355924, ISSN: 0022-0248, DOI: 10.1016/S0022-0248(01)02113-3
- P Schmuki ET AL: "Initiation and Formation of Porous GaAs", J. Electrochem. Soc.,, 1 October 1996 (1996-10-01), pages 3316-3322, XP055313929, Retrieved from the Internet: URL:http://jes.ecsdl.org/content/143/10/33 16.full.pdf [retrieved on 2016-10-25]

## Description

The present invention relates to a method of growing thick single-crystal compound semiconductor material and the material thus produced, for example by material hydride vapour phase epitaxy (HVPE) deposition using nanocolumn compliant layers produced by molecular beam epitaxy (MBE), chemical vapour deposition (CVD), metalorganic chemical vapour deposition (MOCVD), which is also known as metalorganic vapour phase epitaxy (MOVPE) and HVPE.

Wide band-gap GaN and related materials are recognized to be among the most attractive compound semiconductors for use in a variety of devices. They are adapted for optoelectronic and microelectronic devices which operate in a wide spectral range, from visible to ultraviolet and in the high temperature/high power applications area. The main advantages of nitride semiconductors in comparison with other wide-band-gap semiconductors is their low propensity to degrade at high temperature and high power when used for optical and microelectronic devices. Meanwhile, low-dimensional quantum confinement effects (i.e. in quantum wires and dots) are expected to become one of the foremost technologies for improving optical device performances. Fabrication of a variety of low-dimensional structures in III-V nitrides has been undertaken using methods such as etching, re-growth, overgrowth on selected areas, growth on tilted substrates, self-organization process, etc.

Despite the technological advances of the last few years, one of the key obstacles preventing further developments in GaN devices is the lack of high quality and commercially available low-cost, free-standing GaN substrates. Alternative substrates, such as sapphire and SiC are commonly employed in nitride-based devices. As a result of lattice mismatch and large differences in the thermal expansion coefficients between the deposited film and substrate (heteroepitaxy), a very high (10⁹ to 10¹⁰ cm⁻²) density of threading dislocations and serious wafer bending/cracking, induced by undesired residual strain, occurs in the grown nitride layers. These factors can significantly affect the performance and lifetime of nitride-based optoelectronic and microelectronic devices.

Epitaxial lateral overgrowth technique (so-called ELOG and its modifications facet initiated epitaxial lateral overgrowth (FIELO) and Pendeo (from the Latin to hang or be suspended)) is the most widely used approach employed for suppressing bending and a significant fraction of the threading dislocations in the material. Laterally overgrowing oxide (or metal) stripes deposited on initially-grown GaN films has been shown to achieve about two orders of magnitude reduction in the dislocation density, reducing it to the 10⁷ cm⁻² level. However, the low defect-density material only occurs in the wing region, located in the coalescence front, and represents only approximately one fifth of the whole wafer surface area. Large coalescence front tilting and tensile stress are both present in the overgrowth region.

Low defect-density free standing GaN is currently one of the materials of choice to achieve the desired specification for optoelectronic and microelectronic devices. Bulk (melt or sublimation) and hydride vapour phase epitaxy (HVPE) are the two main techniques for growing free standing and low defect-density GaN. Bulk GaN growth techniques operating at a very high pressure of ∼15kbar have been successful in growing low dislocation density (<10⁷ cm⁻²) material. Unfortunately, this technology suffers from a low growth rate and is limited to small diameter substrates, making them very expensive and uneconomic for commercial manufacturing. The record nitride laser lifetime of 15,000 hours under CW-operation at the 30mW output level has recently been demonstrated by Nichia Chemicals Inc., using the HVPE grown substrate. HVPE is clearly one of the most promising techniques available to provide low defect-density GaN and large diameter commercial free-standing GaN substrates.

HVPE is a reversible equilibrium-based hot-wall process with several advantages: (1) high growth rate (up to 100 µm/hr - more than 100 times faster than that of the MOCVD and MBE methods); (2) low running costs; (3) the mutual annihilation of mixed dislocations lowers the defect densities in thick GaN. However, the HVPE technique still has the same inherent problems due to its growth on a foreign substrates. Therefore, the growth of thick GaN using HVPE in general has to overcome two critical issues; firstly, to reduce the bending and cracking of initial GaN thick films (30-100 µm) on foreign substrates and secondly, to minimize the defect density of GaN.

The cracking of thick GaN film, due to the use of foreign substrates, depends on the growth and cooling conditions. The critical thickness for crack appearance in GaN can be improved from a typical value of 10-15 µm for GaN grown conventionally by the HVPE directly onto sapphire substrates, to 40-80 µm-thick crack-free layers by the use of reactively sputtered AlN buffer layers, or by employing ZnO buffer layers. However, even this thickness is not sufficient for safe handling during substrate separation. To further reduce the cracking in thicker GaN films in the initial growth, other growth techniques such as ELOG, growth on patterned substrates, re-growth with molten Ga interfacial layers, use of substrates better matched to GaN, and the use of thinned and mechanically weakened sapphire substrates have also been exploited.

To reduce defect density (mainly threading dislocations) and strain, and to improve the surface morphology of the thick GaN films grown by HVPE, various techniques have been employed, for example ELOG, growth under lower reactor pressure and growth with TiN intermediate layers, or deep inverse pyramid etch pits on weakened Si, GaAs and other III-V single crystal wafers. However, the growth processes using these techniques are tedious, time consuming and expensive. The GaN thus produced still has the major disadvantages of bending and undesired residual strain.

Various vapour deposition methods suitable for growing GaN materials are described in US 6,413,627, US 5,980,632, US 6,673,149, US 6,616,757, US 4,574,093 and US 6,657,232. Other publications relating to such methods include:
1. Handbook of Crystal Growth, Vol 3, edited by D.T.J.Hurle, Elsevier Science 1994.
2. R.F. Davis et al,' Review of Pendeo-Epitaxial Growth and Characterization of Thin Films of GaN and AlGaN Alloys on 6H-SiC(0001) and Si(111) Substrates.' MRS Internet J. Nitride Semicond. Res. 6, 14, 1(2001).
3. M. Yoshiawa, A. Kikuchi, M. Mori, N. Fujita, and K. Kishino, 'Growth of self-organised GaN nanostructures on Al2O3 (0001) by RF-radical source molecular beam epitaxy.' Jpn. J. Appl. Phys., 36, L359 (1997).
4. K. Kusakabe, A. Kikuchi, and K. Kishino, 'Overgrowth of GaN layer on GaN nano-columns by RF-molecular beam epitaxy.' J. Crystl. Growth., 237-239, 988 (2002).
5. J. Su et al, 'Catalytic growth of group III-nitride nanowires and nanostructures by metalorganic chemical vapor deposition.' Appl. Phys.Lett., 86, 13105 (2005).
6. G. Kipshidze et al, 'Controlled growth of GaN nanowires by pulsed metalorganic chemical vapor deposition.' Appl. Phys.Lett., 86, 33104 (2005).
7. H.M. Kim et al, 'Growth and characterization of single-crystal GaN nanorods by hydride vapor phase epitaxy.' Appl. Phys. Lett., 81, 2193 (2002).
8. C.C. Mitchell et al., Mass transport in the epitaxial lateral overgrowth of gallium nitride.' J. Cryst. Growth., 222, 144 (2001).
9. K. Hiramatsu., Epitaxial lateral overgrowth techniques used in group III nitride epitaxy.' J. Phys: Condens, Matter., 13, 6961 (2001).
10. R.P. Strittmatter, 'Development of micro-electromechnical systems in GaN', PhD Thesis, California Institute of Technology, P.92 (2003).

It is an object of the present invention to provide a method of growing high-quality flat and thick compound semiconductors which at least partially overcomes the problems discussed above. In this context, a "thick" semiconductor is one that is substantially self-supporting, typically of thickness greater than about 50µm.

In accordance with the present invention there is provided a method of producing single-crystal compound semiconductor material comprising:
(a) providing a substrate material having a compound semiconductor nanocolumn grown onto it to provide an epitaxial-initiating growth surface;
(b) growing a compound semiconductor material onto the nanocolumn using epitaxial lateral overgrowth; and
(c) separating the grown compound semiconductor material from the substrate,
wherein the nanocolumn is grown with single doped or undoped material, or with the combination of un-doped and doped steps, or n-doped and p-doped steps, and,
wherein the nanocolumn includes a p-type region proximate the growth surface.

Preferably, the compound semiconductor material is selected from the group consisting of III-V and II-VI compounds.

Preferably, the substrate material is selected from the group consisting of sapphire, silicon, silicon carbide, diamond, metals, metal oxides, compound semiconductors, glass, quartz and composite materials. Substrates of different crystal orientation can be used, for example: c-plane sapphire, γ-plane sapphire, m-plane 4H and 6-H SiC. By using nanocolumns fabricated on substrates of different crystal orientation, high quality, low strain and low defect density non-polar and polar compound semiconductor layers can be overgrown. For the growth of normal polar materials such as c-plane GaN, the crystal orientation of the substrate can be c-plane sapphire. For the growth of non-polar materials such as a-plane or m-plane GaN, the crystal orientation of the substrate can be γ-plane sapphire or m-plane 4H- or 6H- SiC respectively.

If γ-plane sapphire is used as the substrate, non-polar a-plane GaN can be grown using nanocolumn compliant layers. The a-plane GaN thus grown will have very low strain and low defect density. M-plane GaN can be grown on (100) LiAlO2, m-plane 4H- or 6H- SiC using nanocolumn compliant layers.

The substrate material may also be selected from the group consisting of conductive substrates, insulating substrates and semi-conducting substrates. The substrate may comprise a compound semi-conductor material previously produced by a method in accordance with the first aspect. The quality of the compound semiconductors produced by the invention is such that they may be used as seed substrates for future growths. For use as a substrate, the semiconductor material may be sliced to the required thickness if necessary, and will usually be lapped and polished before use.

Step (a) may include the step of growing the compound semiconductor nanocolumn onto the substrate. In other words, the substrate and nanocolumn formation is prepared specifically to grow the compound semiconductor. Alternatively, the substrate and nanocolumn formation may be pre-prepared. For example, the formation may be re-used after removal of a previously grown semiconductor. When growing the nanocolumn, at least one nano-island may be created on the substrate material prior to growing the nanocolumn. This step facilitates growth of the nanocolumns. The nano-island may be created by treating the substrate by at least one of nitridation, sputtering, metal deposition and annealing, CVD and MOCVD.

The nanocolumn may be grown using an HVPE method, or alternatively a CVD method, a MOCVD method or an MBE method.

The nanocolumn includes a p-type region proximate the growth surface. The inclusion of such a region may assist with removal of the overgrown semiconductor, for example when using an anodic electrochemical selective etch process.

Preferably, the nanocolumn comprises a material selected from the group consisting of GaN, AlN, InN, ZnO, SiC, Si, and alloys thereof.

The compound semiconductor material may optionally comprise a different material from the nanocolumn.

The epitaxial lateral overgrowth of compound semiconductor material may be carried out by an HVPE method.

The epitaxial lateral overgrowth of compound semiconductor material may be either undoped, or n- or p-type doped.

The epitaxial lateral overgrowth of compound semiconductor material may be time-modulated.

Advantageously, step (b) is performed while rotating and/or lowering the substrate. The grown compound semiconductor material may be separated from the substrate by rapidly cooling the material. Alternatively, it may be mechanically separated, or separated from the substrate by wet etching or electrochemical etching, or by laser ablation. In the case of laser ablation, the laser may be directed toward the substrate-semiconductor material interface from the side of the column, or alternatively up through the substrate.

The grown compound semiconductor may be sliced to produce a semiconductor layer of preselected thickness.

An exemplary method in accordance with the invention utilizes HVPE to grow high quality flat and thick compound semiconductors onto foreign substrates using nanocolumn compliant layers. Nanocolumns of semiconductor materials can be grown on any foreign substrates by MBE, CVD, MOCVD (MOVPE) or HVPE methods. Such nanocolumns may typically have a diameter of about 10 to 120 nm. Mechanical confinement in nanocolumns grown on foreign substrates provides a mechanism for the stress and dislocations to be localized in the interface between the nanocolumns and the substrate. Thus growth will lead to the top part of the nanocolumns being nearly free of stress and dislocations. Further growth of continuous compound semiconductor thick films or wafer can be achieved by epitaxial lateral overgrowth using HVPE. Compound semiconductor thick film and wafer bending due to the thermal expansion coefficient difference between the compound semiconductor materials and the substrate can be minimized by a balanced dimension of the nanocolumn and air gap, which functions to relax the biaxial strain. Both thick and flat compound semiconductor films can therefore be grown using this technique. Localized stress between the nanocolumn and substrate also allows the thick semiconductor, for example GaN to be readily separated from the substrate during rapid cooling. An anodic electrochemical selective etch process for p-GaN can also be used to separate the GaN film from the substrate when a thin p-GaN is grown on the tip of the nanocolumn before the epitaxial lateral overgrowth. The thick GaN may then undergo slicing, grinding, lapping, and polishing processes to produce polar and non-polar compound semiconductor wafers.

The growth processes provided by the invention can be applied to the family of III-V nitride compounds, generally of the formula InₓGa_{y}Al_{1-x-y}N, where 0≤ x ≤1, 0 ≤ y ≤1, and 0 ≤ x+y ≤1, or other suitable semiconducting nitrides. Group II-VI compounds may also be suitable for production through the methodology of the present invention. The semiconductor may for example comprise materials such as GaN, AlN, InN, ZnO, SiC. Throughout the following description, the invention is described using GaN as an example of an epitaxial III-V nitride layer as the semiconductor material for convenience, though any suitable semiconducting material may be used.

The hydride-vapour phase epitaxy (HVPE), also called chloride transport chemical vapour deposition, of GaN is a relatively well-established process based on the gaseous transport of the group III and group V elements to the deposition zone of a growth reactor. In this technique Cl is used to transport the group-III species instead of organometallic sources in the MOCVD technique. This has a distinct advantage in that large growth rates (up to 120 µm/hr) can be achieved by this technique over the MOCVD or the MBE methods (≤2 µm/hr). In contrast to MOCVD, which is a non-equilibrium cold-wall reactor-based technique, HVPE is a reversible equilibrium-based process in which a hot-wall reactor is employed. The typical growth procedure is as follows. Sapphire, silicon carbide, zinc oxides or other compatible substrates are inserted into the deposition zone of the growth chamber and heated. When the final growth temperature is reached the NH₃ flow is started. After a period to allow the NH₃ concentration to reach a steady-state value, HCl flow is started to provide transport of the gallium chloride (GaCl), which is synthesized by reacting HCl gas with liquid Ga metal in the Ga zone at 800-900°C via the reaction: 2HCl(g) + 2Ga(I) → 2GaCl(g) + H₂ (g). An alternative method of synthesis is by reacting Chlorine gas with Ga metal around 125°C. Then gaseous GaCl is transported from the Ga zone to the deposition zone to react with NH₃ at 900-1200°C to form GaN via the reaction GaCl(g) + NH₃(g) → GaN(s) + HCl(g) + H₂ (g). The thickness of deposited GaN layer using this technique is typically up to 800 µm. Another major advantage of the HVPE growth method is the mutual annihilation of mixed dislocations lowering the defect densities in thick GaN. These characteristics make HVPE an ideal technology for manufacturing free-standing GaN and other related III-V nitrides substrates at low cost.

The growth temperature in the HVPE method is rather high (∼1000°C) and, hence, one major problem of growing thick GaN film is the possibility of cracks and lattice defects due to the use of foreign substrate, for example sapphire. It follows that there may also be mismatch in the lattice constants and thermal expansion coefficient between the GaN layer and the substrate).

The present invention provides a novel method for growing flat, low defect density, and strain-free thick semiconductor on any foreign substrates using a nanocolumn compliant layer with an HVPE growth process. The use of GaN nanocolumns, for example, as the compliant layer to grow thick GaN has several advantages. The mechanical confinement occurs between the interface of the nanocolumns and substrate due to the small diameter and the high aspect ratio of the column (height versus diameter). The stress and dislocations are mostly localized in the interface between the GaN nanocolumns and the substrate. Thus growth leads to the top part of the GaN nanocolumns being nearly free of stress and dislocations. In addition, the defects caused by the mosaic structure in conventional GaN films, arising from a spread of initial island misorientations can be minimised, since badly misoriented nanocolumns eventually grow out, improving the general alignment. The topography of nanocolumns with a narrow air gap permits coalescence with a very thin overgrown layer. Typically only -0.2 µm thickness is required for continuous overgrown GaN layers. With all the advantages described above, high-quality thick GaN can therefore be grown on this nanocolumn compliant layer, and has very little tilting in the coalesced front either on top of the nanocolumns or on top of the air gap in comparison with other ELOG or Pendeo processes.

GaN wafer bending due to the thermal expansion coefficient difference between the GaN and the substrate is also minimized by a balanced dimension of the nanocolumn and air gap, which functions to relax the biaxial strain. Thick and flat GaN films can therefore be grown using this technique, including so-called GaN "boules" which may be sufficiently thick to be sliced into multiple wafers. Localized stress between the nanocolumn and substrate also allows the thick GaN to be readily separated from the substrate during the rapid cooling, particularly if a tensile-stressed thin layer is grown between the nanocolumn and the substrate. An anodic electrochemical selective etch process for p-GaN can also be used to separate the GaN film from the substrate. The thick GaN, i.e. a boule, may then undergo slicing, grinding, lapping, and polishing processes as appropriate to produce standard thickness (-250 µm) GaN wafers in a process designed to produce commercial quantities. A wafer produced in this way may be used as the substrate for a further process in accordance with the present invention.

GaN nanocolumns can be grown by MBE using an RF-plasma nitrogen source. If sapphire substrate is used, a nitridation process is preferably conducted first. AlN nucleation layers need to be deposited at a temperature higher (∼850°C) than that of the normal GaN growth process. The purpose of this higher nucleation temperature is to achieve a desired ratio of the top surface area versus the base, which in turn initiates the nanocolumn growth. During growth, the nitrogen flow rate and RF input power can be optimised to produce high density island structures. The targeted island features typically have a height of 5-10 nm and density of ∼10¹⁰ cm⁻². GaN nanocolumns will typically be grown under a N-rich atmosphere, as RF-MBE growth under Ga-rich conditions does not result in nanocolumn growth. The MBE growth parameters may be optimised in order to achieve the desired dimension, aspect ratio, and density of nanocolumns. In-situ Reflection High Energy Electron Diffraction (RHEED) may be used to monitor the 3D island nucleation and GaN nanocolumn growth. To further enhance the growth of nanocolumns with smooth side walls, n-type Silicon doping is preferably employed, since Si doping can significantly enhance the growth rate along the (0001) direction. The morphology of the top facet of nanocolumns can also be manipulated by doping, using different nitride alloys and growth temperature.

Nanocolumns can also be grown using CVD, MOCVD, and HVPE methods. In a MOCVD growth method, catalytic vapour-liquid-solid growth mechanism using In or Ni as the catalyst to initiate the growth combined with pulsed injection of metalorganics and NH₃ are used to obtain controlled growth of GaN nanocolumns. To further refine the control of the top facet morphology, the dimension, aspect ratio and density of nanocolumns, process parameters in MOCVD such as various doping, reactor pressure, reactor temperature, III/V ratio and injection pulse patterns are varied.

GaN nanocolumn growth in HVPE is ideally carried out at very low growth temperature (<500°C) to minimize the surface diffusion and lateral growth.

Both GaN nanocolumn templates and GaN nanocolumn templates with initial thin continuous GaN grown by ELOG using MBE or MOCVD can be loaded for the thick GaN ELOG growth using HVPE. The observed evolution of the ELOG GaN morphology is sensitive to the growth parameters, in particular the temperature and pressure. This infers that the ELOG morphology can be seriously affected by the temperature distribution across the wafer, with resulting differences in the height and morphology of ELOG GaN. Thus temperature uniformity is a strong requirement for HVPE growth. In the HVPE system the temperature uniformity can be controlled using multi-zone substrate heaters combined with lower temperature hot-wall furnace heating systems. The substrate holder may also be equipped with a lowering mechanism to maintain the same distance between the gas outlet and the substrate surface. Process parameters such as reactor temperature, pressure, total gas flow, and V/III ratio may be systematically varied for the growth of thick flat films.

The separation of the grown GaN can be achieved by the following methods. In brittle materials such as sapphire and III-V nitrides, cracking may occur easily when the tensile stress exceeds a critical value. The cracking of the epitaxial layer under compressive stress requires much higher stress and tends not to occur in normal circumstances. GaN nanocolumns with their inbuilt flexibility, due to their aspect ratio and nano-dimensions, will develop minimal internal stress. In order to separate the thick GaN from the substrate with ease and reproducibility, an AlN nucleation layer, under tensile stress, with a critical dimension may be used. Rapid cooling or mechanical twisting will push the local stress to exceed the critical value to separate the thick film. Another method of separating the GaN from the substrate is to use anodic electrochemical etching. In this case, a thin p-GaN layer can be grown on top of the nanocolumn before the epitaxial lateral overgrowth for thick GaN. Using a suitable electrolyte and bias voltage results in p-GaN being selectively etched off, to leave the n-GaN untouched.

Spectroscopic reflectance (SR) allows the measurement of the superposition of lateral interference and vertical interference which can provide both strain and thickness information on the layers. Reflectance measurements at the same wavelength as pyrometry allow the determination of the actual emissivity of the wafer, which in turn enables measurement of the true temperature of the wafer. SR can also help to measure and define the stage of the formation of 3D nucleation islands and the coalescence in the nanocolumn and ELOG growth process. This is essential for the control of nanocolumns and thick film growth.

Specific embodiments of the invention will now be described with reference to the accompanying drawings, in which:
Fig.1. schematically shows a sectional view of a vertical HVPE reactor;
Fig.2 is a schematic illustration of nanocolumns with inclined facets;
Fig.3 is a schematic illustration of nanocolumns with flat top facets;
Fig.4 is a schematic illustration of epitaxial lateral overgrowth of compound semiconductor materials on top of nanocolumns; and
Fig.5 is a schematic illustration of epitaxial lateral overgrowth of compound semiconductor materials on top of the nanocolumns with a p-doped tip layer.

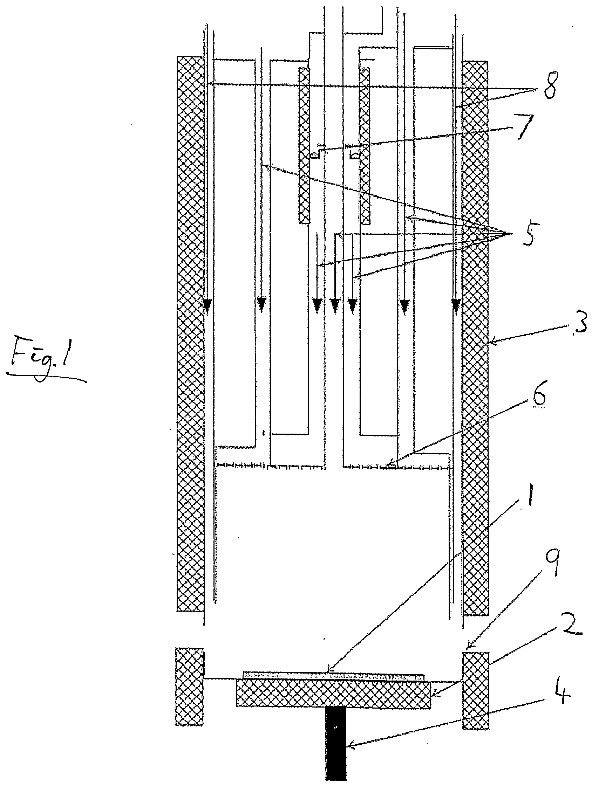

Fig. 1 shows an HVPE reactor suitable for use with the present invention. A substrate 1 is placed on a heater platform 2, near the base of an oven 3. The platform may be vertically moved and / or rotated by means 4. The top half of the oven 3 contains inlets 5 for the various process gases to be introduced to the substrate. These inlets allow process gases to pass to the substrate via mixing frits 6. A Ga crucible 7 is located within one of these inlets. There are also inlets for purging gas 8. Proximate the substrate are gas outlets 9. Various practical Examples are described below. Examples 1 to 7 are not according to the invention. Examples 8 and 9 are according to the invention.

### EXAMPLE 1

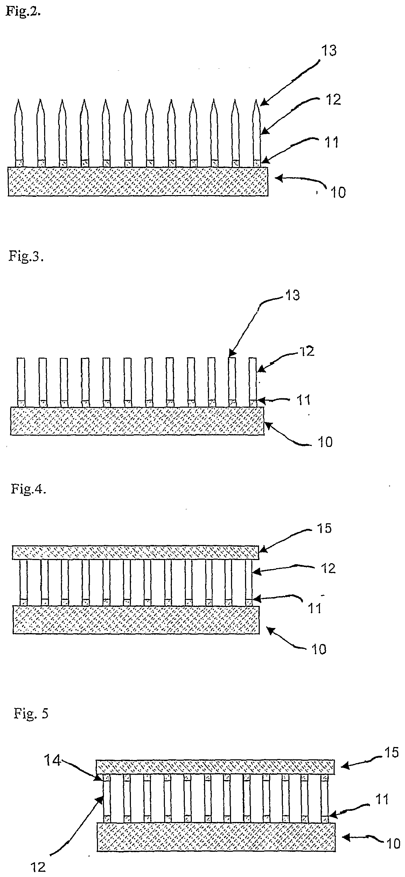

A c-plane-oriented sapphire substrate of about 2 inches (5.08 cm) in diameter is loaded onto the substrate holder of the HVPE vertical reactor described above and shown in Fig. 1. Before loading, the sapphire substrate is degreased in KOH for few seconds, rinsed in deionized water, etched in a H₂SO₄/H₃PO₄=3:1 solution at 80°C for few minutes, then rinsed in deionized water. The gas heater is heated to temperature of about 500°C. N₂ is introduced through all gas injectors for about 30 minutes to purge the reactor. The pressure of the growth chamber is maintained at 300 mbar. The substrates are heated to temperature of about 350°C. NH₃ flow at about 1000 sccm is introduced into the chamber. The GaCl gas precursor is produced by passing 10% HCl in N₂ through a Ga bubbler heated to 800°C. The conversion rate is nearly 100% for GaCl. Then the substrates are heated to a temperature of about 850°C. Gas delivery to the growth chamber is set as follows for the initial nitridation process: NH₃ flow at about 1040 sccm, no GaCl flow and N₂ and H₂ to make the rest of the gas. A N₂ flow of about 2400 sccm and a H₂ flow of about 60 sccm is divided among the gas inlets. A steady total gas flow about 3500 sccm is maintained through the whole 10 minutes nitridation processes. Then the substrate temperature is lowered to 480°C. Gas delivery to the growth chamber is set as follows for the nanocolumn growth process: NH₃ flow at about 1000 sccm, GaCl flow at 60 sccm, and N₂ and H₂ to make the rest of the gas. An N₂ flow of about 2380 sccm and an H₂ flow of about 60 sccm is divided among the gas inlets. A steady total gas flow about 3500 sccm is maintained through the whole growth processes. The GaN nanocolumn HVPE growth process is carried out for about 3 hours. GaN nanocolumns with diameter around 60-120 nm and height around 380 nm are grown by this method. Fig. 2 illustrates the nitridation layers 11, and the grown nanocolumns 12 by HVPE with diameter around 80-120 nm and height around 350-380 nm. Inclined facets 13 in the tip of the nanocolumns are observed.

For the epitaxial lateral overgrowth, the pressure of the growth chamber is raised to 700 mbar. Gas delivery of NH₃ is raised to 2000 sccm, then the substrate's temperature is ramped to about 1050°C in 20 minutes. The GaN growth step is continued until a GaN epitaxial layer of sufficient thickness is produced. During the growth, the substrate is lowered down through the rotation lowering mechanism of the substrate holder to maintain the constant distance between the gas frits and the substrate. For the growth with the V/III ratio set between 10 and 40 in the vertical HVPE reactor of Fig. 1, a growth rate of between about 20 µm/hour and about 160 µm/hour can be achieved. Uniformity of the growth without the aided rotation is better than 2% from edge to edge in a 2 inch (5.08 cm) wafer. Fig. 4 illustrates the thick GaN 15 grown by ELOG onto nanocolumns 12.

In the nitride growth termination, GaCl gas is switched off, flow of NH₃ is maintained at the same level and N₂ flow is increased to make up the steady total gas flow. The substrate cool-down is controlled in a process steps of higher than 50°C / min between 1050°C and 500°C. The flow of NH₃ is then switched off below the temperature of 500°C. The cool-down continues with a rate less than 100°C / min between 500°C and room temperature. During this time, the gas heater maintains the temperature at about 350°C and the substrate is lowered down from the chamber to maintain the cool-down rate at less than 100°C / min.

Once the substrate is cooled and removed from the reactor, the sapphire substrate can be seen totally or partially separated from the thick GaN epitaxial layer. A further mechanical twist is sufficient to separate the partially separated GaN layer.

### EXAMPLE 2

In this example, the nanocolumn HVPE growth process described in Example 1 above is replaced by the following pulsed MOCVD growth process. A thin layer, around 5 nm, of Ni is deposited by electron beam evaporation onto the c-plane oriented (0001) sapphire substrate. The Ni coated sapphire is then loaded into a MOCVD reactor. The substrate is heated to about 800-850°C under the N₂ flow to form dispersed Ni islands on the surface. H₂ is used as the carrier gas and the reactor pressure is kept at 100 mbar. NH₃ flow is 1000 sccm and Trimethylgallium (TMG) flow is 36 sccm. The substrate temperature is then lowered to around 700-800°C. Vapour-liquid-solid (VLS) growth commences with the pulsed injection of 2-6 seconds TMG, followed by a 2-6 second delay, then a further 2-6 seconds NH₃. During the TMG injection, NH₃ is switched off. During the NH₃ injection, TMG is switched off. This causes reduced pre-mixing particulates to be formed using this process. The lower temperature, compared to Example 1, significantly reduces the lateral diffusion. The nanocolumn template is then dipped into HCl solution to remove dispersed Ni metals on the template. GaN nanocolumns grown for one hour this way typically have diameters of 90-100 nm and heights of around 680 nm. Fig. 3 illustrates the nanocolumns with flat facets 13 on the top grown by MOCVD in un-doped conditions.

### EXAMPLE 3

Here, the nanocolumn HVPE growth process described in Example 1 above is replaced by the following pulsed MOCVD growth process. A surface nitridation step is carried out for about 5 minutes with the reactor pressure at about 100 mbar, substrate temperature about 800°C, and NH₃ flow at about 1200 sccm. The substrate temperature is then raised to about 850-900°C. The NH₃ flow is adjusted to about 1000 sccm and TMAI was adjusted to about 15 sccm. High density AlN islands growth is carried out using the pulsed injection of 2-6 seconds TMAI, followed by a 2-6 second delay and then 2-6 seconds NH₃. The AlN growth typically takes about 10-30 minutes. An AlN islands density of around 10¹⁰ cm⁻² may be achieved by this method. The substrate temperature is then lowered to around 700-750°C. NH₃ flow is set to about 1000 sccm and Trimethylgallium (TMG) flow to about 36 sccm. GaN nanocolumn growth is carried out under H₂ with the pulsed injection of 2-6 seconds TMG, followed by a 2-6 second delay and then 2-6 seconds NH₃. GaN nanocolumns 12 grown for about two hours this way typically have diameters of around 60-120 nm, and heights of around 800-1000 nm.

### EXAMPLE 4

Here, the nanocolumn HVPE growth process described in Example 1 above is replaced by an MBE growth process. The active nitrogen species are supplied by a radio frequency (RF) plasma source using high purity N₂ as the feeding gas. Al and Ga are supplied from effusion cells using high purity metals. The N₂ flow is set at about 2 sccm and RF power is set as about 450 W. A surface nitridation step is then carried out for about 5 minutes at around 700°C. The substrate temperature is then raised to about 850-900°C. High density AlN islands growth is carried out for about 5-10 minutes. Then GaN nanocolumns are grown under the same temperature for around another two hours. GaN nanocolumns produced in this manner are typically found to have diameters of -90 nm and heights of -800 nm.

### EXAMPLE 5

Here, the HVPE epitaxial lateral overgrowth process described in Example 1 is replaced by a time-modulated HVPE growth method. In this method, the flow sequence of reagent gases is on (NH₃ and GaCl on) and off (GaCl and NH₃ off, HCl on) in turn for the growth mode and the etching mode respectively. The time for the on and off period is set to be around 3 minutes and 1 minute respectively. The HCl flow during the etching is set at 80 sccm. The GaN growth step is continued until a GaN epitaxial layer of sufficient thickness is produced. For the growth with the V/III ratio set between 10 and 40 in the vertical reactor of Fig. 1, a growth rate of around 30 -120 µm/hour can be achieved. This method may produce a reduced defect density compared to that of normal HVPE growth.

### EXAMPLE 6

Here, the HVPE epitaxial lateral overgrowth process described in Example 5 is replaced by a modified time-modulated HVPE growth. The growth is divided into etch, annealing, enhanced lateral growth and normal growth stages. In this example the flow of reagent gases for the etch stage is GaCl and NH₃ off, HCl on with gas flow of 80 sccm. For the annealing stage the flow is GaCl and HCl off, NH₃ on. For the enhanced lateral growth stage the flow is GaCl and NH₃ on, HCl on with gas flow of 5 sccm, total H₂ flow increases from 60 to 200 sccm. Finally, for the normal growth stage the flow is GaCl and NH₃ on, HCl on with gas flow of 5 sccm, total H₂ flow of 60 sccm. The time for the etch, annealing, enhanced lateral growth and normal growth periods is set to be 1, 1, 3 and 2 minutes respectively.

### EXAMPLE 7

Here, the nanocolumn HVPE growth process described in Example 1 is modified by doping the GaN with silane (2% in H₂) with gas flow from 2 to 20 sccm for n-GaN nanocolumns.

### EXAMPLE 8

Here, the nanocolumn HVPE growth process described in Example 1 is modified by adding an extra p- type GaN layer in the final stage of nanocolumn growth. The p-GaN is doped with Mg using Cp₂Mg or Magnesium vapour injected through gas inlet 8 with a flow of around 7 to 50 sccm (Cp₂Mg bubbler pressure 1000 mbar, bubbler temperature 25°C, carrier gas H₂). Fig. 5 illustrates the thick GaN grown by ELOG onto nanocolumns with p-GaN top layer 14.

### EXAMPLE 9

In this Example, the thick GaN grown in Example 1, being n-type doped with a modified p-GaN top layer of the nanocolumns as produced in Example 8, is separated from the substrate using an electrochemical method. The thick n-GaN acts as the anode, a Pt mesh is used as the cathode and either KOH or H₃PO₄ is used as the electrolyte. A bias voltage (to Pt reference electrode) of about 3.5 to 4 V is applied to selectively etch away the p-GaN. The thick n-GaN is typically separated from the substrate after 30 minutes etching.
It will be apparent to those skilled in the art that a wide range of methods and process parameters can be accommodated within the scope of the invention, not just those explicitly described above. For example, nanocolumn growth may be initiated in a variety of ways, which will be apparent to those skilled in the art. The nanocolumns may be grown so as to have various shapes of tips, chosen as appropriate for the application in hand. The material of the nanocolumn does not have to be constant, for example the alloy content may be varied along its height so that its properties are most suitable for the specific application. For example, the alloy content may be selected so as to optimise absorption during a laser ablation separation process. Alternatively, a change in the alloy content may optimise the lattice constant for the overgrown semiconductor. Furthermore, the nanocolumn material need not be identical to that of the overgrown compound semiconductor.

In the specific examples described, nanocolumns are grown onto the substrate before overgrowth of the compound semiconductor material. However, use of a nanocolumn layer may permit relatively easy removal of the semiconductor, without causing undue damage to the underlying nanocolumns. In this case, the substrate and nanocolumn formation may be re-used in a subsequent process in accordance with the invention. In other words, a substrate with its nanocolumns may be used more than once or even repeatedly as a base for the overgrowth of compound semiconductor materials. This would have significant cost savings for the second and each subsequent overgrowth.

## Claims

1. A method of producing single-crystal compound semiconductor material comprising:
(a) providing a substrate material having a compound semiconductor nanocolumn grown onto it to provide an epitaxial-initiating growth surface;
(b) growing a compound semiconductor material onto the nanocolumn using epitaxial lateral overgrowth; and
(c) separating the grown compound semiconductor material from the substrate,
wherein the nanocolumn is grown with single doped or undoped material, or with the combination of un-doped and doped steps, or n-doped and p-doped steps, and,
wherein the nanocolumn includes a p-type region proximate the growth surface.

2. A method according to claim 1, wherein the compound semiconductor material is selected from the group consisting of III-V and II-VI compounds.

3. A method according to either of claims 1 and 2, wherein the substrate material is selected from the group consisting of sapphire, silicon, silicon carbide, diamond, metals, metal oxides, compound semiconductors, glass, quartz and composite materials.

4. A method according to any preceding claim, wherein step (a) includes the step of growing the compound semiconductor nanocolumn onto the substrate.

5. A method according to claim 4, comprising the step of creating at least one nano-island on the substrate material prior to growing the nanocolumn.

6. A method according to claim 5, wherein the nano-island is created by treating the substrate by at least one of nitridation, sputtering, metal deposition and annealing, CVD and MOCVD.

7. A method according to any preceding claim, wherein the nanocolumn comprises a material selected from the group consisting of GaN, AIN, InN, ZnO, SiC, Si, and alloys thereof.

8. A method according to any preceding claim, wherein the grown compound semiconductor material is non-polar.

9. A method according to any preceding claim, wherein the grown compound semiconductor material comprises a-plane or m-plane GaN.

10. A method according to either of claims 8 or 9, wherein the substrate comprises γ-plane sapphire or m-plane 4H- or 6H- SiC.

## Patentansprüche

1. Verfahren zum Erzeugen eines Einkristallverbindung-Halbleitermaterials, Folgendes umfassend:
(a) Bereitstellen eines Substratmaterials mit einer darauf gezüchteten Verbindungshalbleiter-Nanosäule, um eine Epitaxie einleitende Wachstumsoberfläche bereitzustellen;
(b) Züchten eines Verbindungshalbleitermaterials auf der Nanosäule unter Einsatz eines epitaxischen lateralen Überwachstums; und
(c) Teilen des gezüchteten Verbindungshalbleitermaterials von dem Substrat,
wobei die Nanosäule mit einfach dotiertem oder undotiertem Material oder mit der Kombination aus undotierten und dotierten Schritten oder n-Dotierten und p-dotierten Schritten gezüchtet wird, und
wobei die Nanosäule eine p-Typ-Region in der Nähe der Wachstumsoberfläche enthält.

2. Verfahren nach Anspruch 1, wobei das Verbindungshalbleitermaterial ausgewählt ist aus der Gruppe bestehend aus III-V- und II-VI-Verbindungen.

3. Verfahren nach Anspruch 1 oder 2, wobei das Substratmaterial ausgewählt ist aus der Gruppe bestehend aus Saphir, Silicium, Siliciumcarbid, Diamant, Metallen, Metalloxiden, Verbindungshalbleitern, Glas, Quarz und Verbundmaterialien.

4. Verfahren nach einem der vorhergehenden Ansprüche, wobei Schritt (a) den Schritt des Züchtens der Verbindungshalbleiter-Nanosäule auf dem Substrat enthält.

5. Verfahren nach Anspruch 4, umfassend den Schritt des Erstellens wenigstens einer Nanoinsel auf dem Substratmaterial vor dem Züchten der Nanosäule.

6. Verfahren nach Anspruch 5, wobei die Nanoinsel erzeugt wird durch Behandeln des Substrats mit Nitrierung, Sputtern, Metallablagerung und Glühen, CVD und/oder MOCVD.

7. Verfahren nach einem der vorhergehenden Ansprüche, wobei die Nanosäule ein Material umfasst, ausgewählt aus der Gruppe bestehend aus GaN, AIN, InN, ZnO, SiC, Si und Legierungen davon.

8. Verfahren nach einem der vorhergehenden Ansprüche, wobei das gezüchtete Verbindungshalbleitermaterial nichtpolar ist.

9. Verfahren nach einem der vorhergehenden Ansprüche, wobei das gezüchtete Verbindungshalbleitermaterial ein a-Ebenen- oder m-Ebenen-GaN umfasst.

10. Verfahren nach einem der Ansprüche 8 und 9, wobei das Substrat γ-Ebenen-Saphir oder m-Ebenen-4H- oder -6H-SiC umfasst.

## Revendications

1. Procédé de production d'un matériau semiconducteur composé monocristallin comprenant les étapes suivantes :
(a) fournir un matériau de substrat ayant une nanocolonne de semiconducteur composé développée sur celui-ci pour fournir une surface de croissance épitaxiale ;
(b) développer un matériau semiconducteur composé sur la nanocolonne en utilisant une surcroissance latérale épitaxiale ; et
(c) séparer le matériau semiconducteur composé développé du substrat,
dans lequel la nanocolonne est développée avec un matériau dopé par un seul élément ou un matériau non dopé, ou avec la combinaison d'étapes non dopées et dopées, ou d'étapes dopées n et dopées p, et,
dans lequel la nanocolonne comprend une région de type p proche de la surface de croissance.

2. Procédé selon la revendication 1, dans lequel le matériau semiconducteur composé est sélectionné dans le groupe constitué de composés III-V et II-VI.

3. Procédé selon l'une ou l'autre des revendications 1 et 2, dans lequel le matériau de substrat est sélectionné dans le groupe constitué de saphir, de silicium, de carbure de silicium, de diamant, de métaux, d'oxydes métalliques, de semiconducteurs composés, de verre, de quartz et de matériaux composites.

4. Procédé selon l'une quelconque des revendications précédentes, dans lequel l'étape (a) comprend l'étape de développement de la nanocolonne de semiconducteur composé sur le substrat.

5. Procédé selon la revendication 4, comprenant l'étape de création d'au moins un nano-îlot sur le matériau de substrat avant la croissance de la nanocolonne.

6. Procédé selon la revendication 5, dans lequel le nano-îlot est créé en traitant le substrat au moyen d'au moins une technique parmi la nitruration, la pulvérisation, le dépôt et le recuit de métaux, le CVD et le MOCVD.

7. Procédé selon l'une quelconque des revendications précédentes, dans lequel la nanocolonne comprend un matériau sélectionné dans le groupe constitué de GaN, d'AIN, d'InN, de ZnO, de SiC, de Si et de leurs alliages.

8. Procédé selon l'une quelconque des revendications précédentes, dans lequel le matériau semiconducteur composé développé est non polaire.

9. Procédé selon l'une quelconque des revendications précédentes, dans lequel le matériau semiconducteur composé développé comprend le GaN plan a ou plan m.

10. Procédé selon l'une ou l'autre des revendications 8 et 9, dans lequel le substrat comprend le saphir plan y ou le 4H- ou 6H-SiC plan m.
